# EUROPEAN PATENT SPECIFICATION

(11) **EP 1 037 212 B1**
(45) Date of publication and mention of the grant of the patent: **17.06.2009**
(21) Application number: 00301899.1
(22) Date of filing: 08.03.2000
(51) Int. Cl.: G11C 7/00

(54) **Semiconductor integrated circuit device**
Integrierte Halbleiterschaltungsanordnung
Circuit intégré à semiconducteurs

(30) Priority: 17.03.1999 JP 7227999
(43) Date of publication of application: 20.09.2000
(73) Proprietor: Oki Electric Industry Company, Limited, Tokyo 105 (JP)
(72) Inventor: Sugio, Kenichiro, c/o Oki Electric Industry Co Ltd, Tokyo 105 (JP)
(74) Representative: Read, Matthew Charles

(56) References cited:
- EP-A- 0 451 453
- US-A- 5 398 207
- US-A- 5 708 622
- US-A- 5 734 914
- US-A- 5 872 737

## Description

### BACKGROUND OF THE INVENTION

### 1. Field of the Invention

The present invention relates to a semiconductor integrated circuit device. More particularly, the present invention relates to a configuration of an output data voltage level conversion circuit in a semiconductor memory circuit device wherein an internal circuit is driven by an internal power supply, while an output driver is driven by an external power supply.

### 2. Description of the Related Art

In recent years, increasing miniaturization in design standards has brought a tendency toward decreasing a withstand voltage of a memory cell in a semiconductor circuit device. Therefore, in a general semiconductor memory device, an internal circuit is driven by an internal power supply (IVCC: Internal VCC) having the voltage thereof reduced to a lower voltage than an external power supply (EVCC: External VCC), and an output driver is driven by the external power supply EVCC. In such a semiconductor memory circuit device, the output driver and other internal circuits use power supplies of different voltages; therefore, it is necessary to convert data voltage levels from internal power supply voltage levels to external power supply voltage levels before transferring read data from an internal circuit to an output driver. Conversion of data voltage levels is performed by, for example, using a level shifter circuit.

The conventional semiconductor memory circuit device, however, converts a data voltage level from an internal power supply level to an external power supply level by using a level shifter circuit provided in a stage before the stage for transferring read data from an internal circuit to an output driver as described above. This results in a data access delay due to multiple stages of the level shifter circuit and a specific operation of the level shifter circuit. The access delay caused by the specific operation of the level shifter circuit may be improved by increasing the current. However, this may lead to a further disadvantage of an increase in current drain, or generation of unexpected noises.

Furthermore, in order to cope with the increasingly accelerating tendency toward higher integration of semiconductor memory circuit devices, it is highly expected to achieve a semiconductor memory circuit configuration obviating the need of a level shifter circuit provided in a stage preceding the output driver, thus rendering another advantage of reserving extra space on a chip.

### SUMMARY OF THE INVENTION

An object of the invention is to provide a semiconductor memory circuit configuration eliminating a level shifter circuit which is conventionally provided in a stage immediately before an output driver.

To this end, according to the present invention, there is provided a semiconductor integrated circuit device comprising an internal power supply operable to receive an external supply voltage and provide a lower internal supply voltage dependent thereon, a first amplifier to amplify a signal from internal circuitry of the device and provide a first amplifier output corresponding thereto, a second amplifier to amplify the first amplifier output and provide a second amplifier output corresponding thereto and an output driver to provide a driver output corresponding to the second amplifier output, wherein the first amplifier is arranged to be driven by the internal supply voltage and the second amplifier and the output driver are arranged to be driven by the external supply voltage.

### BRIEF DESCRIPTION OF THE DRAWINGS

While the specification concludes with claims particularly pointing out and distinctly claiming the subject matter which is regarded as the invention, it is believed that the invention, the objects, features of the invention and further objects, features and advantages thereof will be better understood from the following description taken in connection with the accompanying drawings in which:
Fig. 1 is a circuit diagram showing a first embodiment according to the present invention.
Fig. 2 is a timing chart showing the operation of the first embodiment according to the present invention.
Fig. 3 is a circuit diagram showing a second embodiment according to the present invention.
Fig. 4 is a timing chart showing the operation of the second embodiment according to the present invention.
Fig. 5 is a circuit diagram showing a third embodiment according to the present invention.

### DESCRIPTION OF THE PREFERRED EMBODIMENTS

### First Embodiment

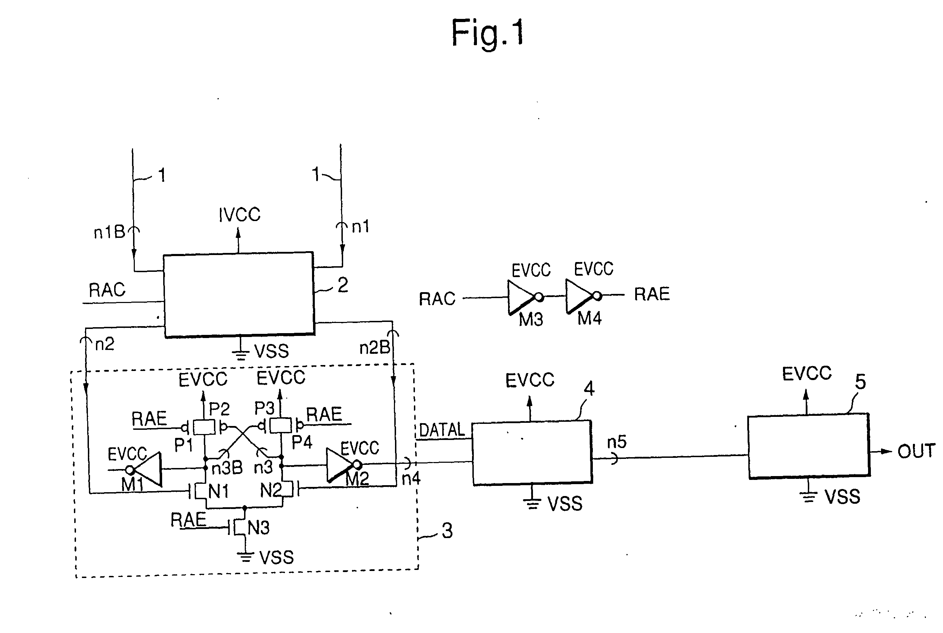

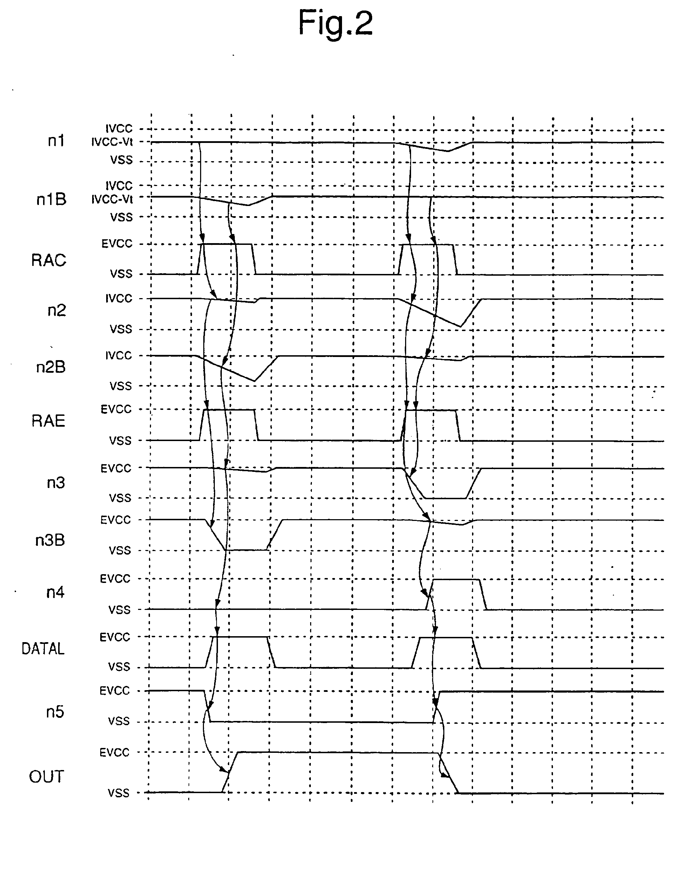

Fig. 1 is a circuit diagram showing a first embodiment according to the present invention. Fig. 2 is a timing chart showing the operation according to the first embodiment. The semiconductor memory circuit shown in Fig. 1 includes a current mirror type amplifier 2 which amplifies the data read onto a data bus 1 from a memory cell by selecting a column line (not shown), a differential amplifier 3 further amplifying the data output from the current mirror type amplifier 2, a data latch circuit 4 latching the data output from the differential amplifier 3 in accordance with a data latch signal DATAL, and an output driver 5 outputting the data output from the data latch circuit 4 to an external source.

The current mirror type amplifier 2 uses an internal power supply IVCC as its power supply, and amplifies the data appearing at nodes n1 and n1B on the data bus 1 in accordance with a read amplifier active signal RAC. A differential amplifier 3 includes four PMOS transistors P1 through P4, three NMOS transistors N1 through N3, and two inverters of M1 and M2. The differential amplifier 3 while using an external power supply EVCC as its power supply, amplifies the data appearing at output nodes n2 and n2B on the current mirror type amplifier 2 according to a row address enable signal RAE. Since the power supply used by the differential amplifier 3 is an external power supply EVCC, the data potential levels at output nodes n4 and n4B of the differential amplifier 3 have been converted into signals with external power supply voltage levels (EVCC levels).

An external power supply voltage level EVCC is used for the "High" level of the read amplifier active signal RAC, the row address enable signal RAE, and the data latch signal DATAL. The row address enable signal RAE is a signal composed of a read amplifier active signal RAC that has been delayed by using two stages of inverters M3 and M4.

The operation will now be described. The data on the data bus 1 is amplified upon a change in the level of the read amplifier active signal RAC from "Low" to "High". At this time, the output nodes n2 and n2B of the current mirror type amplifier 2 start to diverge to the "High" and "Low" levels. The data appearing at the output nodes n2 and n2B is further amplified by the differential amplifier 3 in the following stage upon a change in the level of the row address enable signal RAE from "Low" to "High", and output from an inverter M2. In the data latch circuit 4 provided in the subsequent stage, the data appearing at the output node 4n of the differential amplifier 3 is latched upon a change in the level of the data latch signal DATAL, which is a one-shot pulse signal, from "Low" to "High". The output data from the data latch circuit 4 is then supplied to an external source from the output driver 5 in the subsequent stage.

According to this embodiment, the internal power supply IVCC is used for the current mirror type amplifier 2 in the first stage, and an external power supply EVCC is used for the differential amplifier 3 in the subsequent stage, realizing a semiconductor memory circuit device configuration wherein a level shifter circuit, which is conventionally provided in the stage preceding the output driver, is eliminated. Thus, data can be accessed at a higher speed in a semiconductor memory circuit.

### Second Embodiment

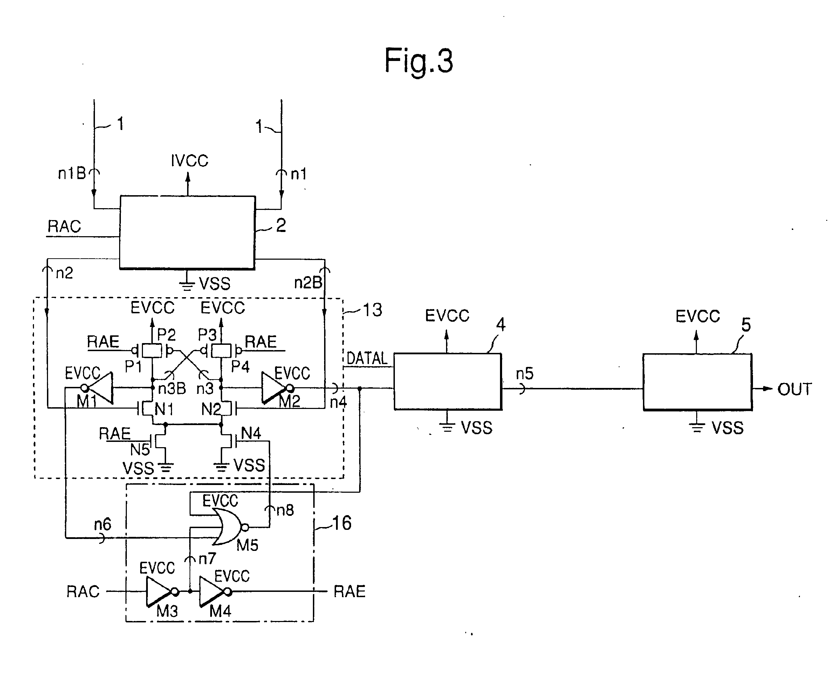

Fig. 3 is a circuit diagram showing a second embodiment of the present invention. The second embodiment is different from the first embodiment in that an NMOS transistor N3 configuring a differential amplifier 13 on the side of a ground voltage VSS is divided into N4 and N5, and a control circuit 16 is provided which inputs a signal based on an output from the differential amplifier 13 to a control gate of an NMOS transistor N4 and a row address enable signal RAE to a control gate of the NMOS transistor N5. This control circuit 16 controls switching between conduction and non-conduction of the NMOS transistors N4 and N5. In this embodiment, an example where NMOS transistor N3 is divided into two is described. The division of the transistor, however, is not limited to two; the transistor may be dividied into three or more.

The semiconductor memory circuit according to this embodiment has the same configuration as shown in Fig. 1 and described in the first embodiment, except that a control circuit 16 is connected to the differential amplifier 13. Therefore, the same numerals will be used, and the description thereof will be omitted. The differential amplifier 13 includes four PMOS transistors of P1 through P4, four NMOS transistors of N1, N2, N4 and N5, and two inverters of M1 and M2. The differential amplifier 13 uses an external power supply EVCC as its power supply, and amplifies the data appearing at output nodes n2 and n2B of the current mirror type amplifier 2 in accordance with a row address enable signal RAE. Since the power supply used by the differential amplifier 13 is an external power supply EVCC, the data potential levels at output nodes n4 and n6 of the differential amplifier 13 have been converted into external power supply voltage levels (EVCC levels).

The control circuit 16 includes two stages of inverters of M3 and M4 to generate a row address enable signal RAE from a read amplifier active signal RAC and output the generated signal, and a three-input NOR circuit M5 using two signals appearing at the two output nodes n4 and n6 of the differential amplifier 13 and a signal appearing at an output node n7 of the inverter M3 as its inputs. The output side of the three-input NOR circuit M5 is connected to the control gate of the NMOS transistor N4, and the output side of the inverter M4 (row address enable signal RAE) is connected to the control gate of the NMOS transistor N5.

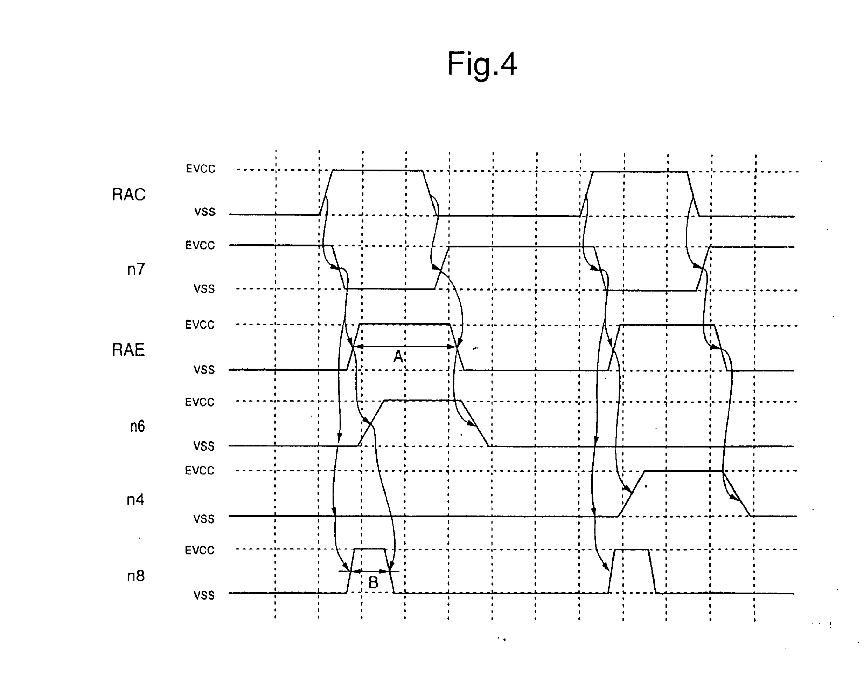

The operation according to the second embodiment will now be described. The operation already described in the first embodiment will not be repeated herein; the operation of the differential amplifier 13 which is a constituent characterizing the second embodiment will be described. Fig. 4 is a timing chart showing the operation of the second embodiment according to the present invention. When a read amplifier active signal RAC is at the "Low" level (when the differential amplifier 13 is not in operation), an output node n8 of the three input NOR circuit M5 goes to the "Low" level since an output node n7 of the inverter M3 is at the "High" level. Thus, the NMOS transistors of N4 and N5 are both turned off. On the other hand, when a read amplifier active signal RAC is at the "High" level (when the differential amplifier 13 is in operation), the output node n8 of the three-input NOR circuit M5 goes to the "High" level since the output node n7 of the inverter M3 is at the "Low" level, and the output nodes n4 and n6 are at the "low" level when starting the operation of the differential amplifier 13. At this time, since the row address enable signal RAE is also at the "High" level, both the NMOS transistors N4 and N5 both turn on.

Then, either of the output nodes of n4 or n6 goes to the "high" level upon amplification of data by the differential amplifier 13. As a result, the level of the output node n8 of the three-input NOR circuit M5 switches from "High" to "Low", so that the NMOS transistor N4 goes off. The read amplifier active signal RAC goes to the "Low" level, and the NMOS transistor N4 is reset once and maintained in the off state until the read amplifier active signal RAC goes to the "High" level again.

As in the case of the first embodiment, the "High" levels in the read amplifier active signal RAC, the row address enable signal RAE, and the data latch signal DATAL used in this embodiment all employ the external power supply voltage level (EVCC level).

With this embodiment, a faster data access operation of a semiconductor memory circuit can be achieved, and the current drain of the differential amplifier 13 can be reduced at the point when the output data of the differential amplifier 13 is fixed, as in the case of the first embodiment. This advantage can be understood from Fig. 4. Figure 4 shows that an active period B of the differential amplifier 13 according to this embodiment is reduced, compared with an active period A of a conventional amplifier. This shortened active period of the differential amplifier has achieved reduced current drain. Furthermore, no incorrect operation due to noise or the like will occur, since the differential amplifier 13 is not completely turned off, i.e., no internal node of the differential amplifier 13 is placed in a floating state.

### Third Embodiment

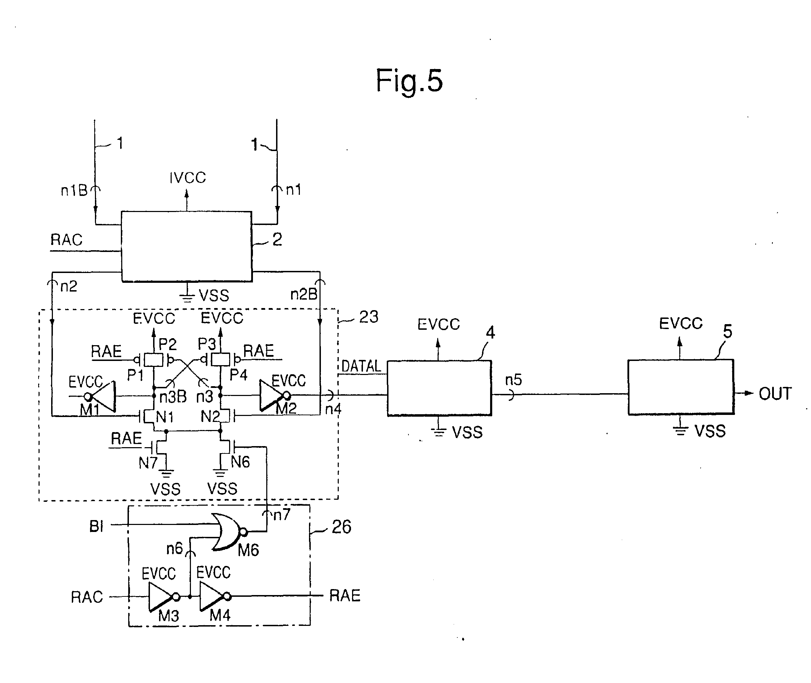

Fig. 5 is a circuit diagram showing a third embodiment according to the present invention. The third embodiment is different from the first embodiment in that NMOS transistors N6 and N7 are connected in parallel to the ground voltage VSS of a differential amplifier 23, and that a control circuit 26 is provided which inputs a signal based on a burn in signal BI to a control gate of an NMOS transistor N6 and inputs a row address enable signal RAE to the control gate of an NMOS transistor N7. This control circuit 26 controls switching between conduction and non-conduction of the NMOS transistors N6 and N7. In this embodiment, an example wherein two NMOS transistors are connected in parallel to a ground voltage VSS is described. The number of NMOS transistors, however, is not limited to two; three or more NMOS transistors may be connected in parallel.

The semiconductor memory circuit according to this embodiment has the same configuration as that shown in Fig. 1 for the first embodiment except that a control circuit 26 is connected to the differential amplifier 23; therefore, the same numerals will be used and the description thereof will not be repeated. The differential amplifier 23 has four PMOS transistors P1 through P4, four NMOS transistors N1, N2, N6 and N7, and two inverters M1 and M2. The differential amplifier 23 uses an external power supply EVCC as the power supply therefor, and amplifies the data appearing at output nodes n2 and n2B of the current mirror type amplifier 2 in accordance with a row address enable signal RAE. As the power supply used by the differential amplifier 13 is the external power supply EVCC, the data of the potential levels at output nodes n4 and n6 of the differential amplifier 13 has been converted to the external power supply voltage level (EVCC level) signals.

The control circuit 26 is composed of two stages of inverters M3 and M4 which generate a row address enable signal RAE from a read amplifier active signal RAC and output the generated signal, and a two-input NOR circuit M6 using a burn in signal BI and a signal appearing at the output node n6 of the inverter M3 as its inputs. The output side of the two-input NOR circuit M6 is connected to the control gate of NMOS transistor N6, and the output side of the inverter M4 (a row address enable signal RAE) is connected to the control gate of the NMOS transistor N7.

The operation according to the second embodiment will be described now. The operation already described in the first embodiment will be omitted; the operation of the differential amplifier 23 in a burn in test, which is a characteristic of the second embodiment, will be described. In a burn in test, a burn in signal BI switches from the "Low" level to the "High" level, causing the output node n7 of the two-input NOR circuit M6 to be switched to the "Low" level. As aresult, the NMOS transistor N6 goes off to prevent current from flowing, which reduces the current passing through the differential amplifier 23, and the differential amplifier 23 operates slower than in normal operation. The burn in test is a type of acceleration test for a semiconductor device, wherein a device is operated with a relatively loose cycle under a high temperature and high voltage environment.

With this embodiment, like the first embodiment, a higher data access operation of a semiconductor memory circuit can be achieved, while a slower operation of the differential amplifier 23 than in the normal operation thereof is allowed since the current passing through the differential amplifier 23 is reduced. This permits a suppressed rise of a peak current caused by high voltage, thus preventing malfunctions of a memory circuit due to power supply noises during a burn in test.

As in the first and the second embodiments, the external power supply voltage level (EVCC level) is used for the "High" level of all the read amplifier active signal RAC, the row address enable signal RAE, and the data latch signal DATAL in this embodiment. The external power supply voltage level (EVCC level) is also used for the "High" level of the burn in signal BI.

As described above in detail, the present invention allows the implementation of a semiconductor memory circuit device configuration that obviates the need of a level shifter circuit conventionally provided in a stage preceding, an output driver. Thus, a faster data access operation in a memory circuit can be implemented, and the absence of a level shifter circuit provides an extra space on a chip. According to another aspect of the present invention, current drain can be reduced and malfuctions due to noises can be prevented.

## Claims

1. A semiconductor integrated circuit device comprising:
an internal power supply operable to receive an external supply voltage (EVCC) and provide a lower internal supply voltage (IVCC) dependent thereon,
a first amplifier (2) to amplify a signal (n1) from internal circuitry of the device and provide a first amplifier output (n2) corresponding thereto;
a second amplifier (3) to amplify the first amplifier output (n2) and provide a second amplifier output (n4) corresponding thereto; and
an output driver (5) to provide a driver output (OUT) corresponding to the second amplifier output (n4);
**characterised in that:**
the first amplifier (2) is arranged to be driven by the internal supply voltage (IVCC), and the second amplifier (3) and the output driver (5) are arranged to be driven by the external supply voltage (EVCC).

2. A semiconductor integrated circuit device according to claim 1, wherein:
the first amplifier (2) is connected between said internal power supply voltage (IVCC) and a third power supply voltage (VSS) and arranged to receive and amplify data read from a memory cell; and
the second amplifier (3) is connected between said external power supply voltage and said third power supply voltage (VSS) and arranged to receive and amplify data of said internal power supply voltage level output from said first amplifier (2) and to convert the level of the data into said external power supply voltage level.

3. A semiconductor integrated circuit device according to claim 1, wherein:
the internal power supply is arranged to provide the internal power supply voltage (IVCC) by generating, in a first area, a predetermined voltage and, in a second area, increasing said generated voltage at a predetermined rate in accordance with a rise in the external power supply voltage (EVCC);
the internal circuitry is operated from the voltage generated in said first area;
the signal amplified by the first amplifier (2) is data read from a memory cell; and
the second amplifier (3) is arranged to convert the first amplifier output to data of the external power supply voltage level.

4. A semiconductor integrated circuit device according to claim 3, wherein the second amplifier (13) is connected between said external power supply and a ground, comprising:
a control circuit (16) arranged to switch between conduction and non-conduction of a MOS transistor (N4, N5) on the ground side of said second amplifier (13) in accordance with an activation signal (RAC) and an output from said second amplifier (13).

5. A semiconductor integrated circuit device according to claim 3, wherein the second amplifier (23) is connected between said external power supply and a ground, comprising:
a control circuit (26) arranged to switch between conduction and non-conduction of a MOS transistor (N6) on the ground side of said second amplifier (23) in accordance with a burn in enable signal (BI) and an activation signal (RAC).

6. The semiconductor integrated circuit device as in any of claims 2 to 5, wherein said first amplifier (2) is arranged to amplify data in accordance with a read amplifier active signal (RAC).

7. The semiconductor integrated circuit device as in any of claims 2 to 6, wherein said second amplifier (3) is arranged to amplify data in accordance with a row address enable signal (RAE).

8. The semiconductor integrated circuit device, according to any of claims 2 to 7, wherein said first and second amplifiers (2, 3) are respectively configured by using a current mirror type amplifier and a differential amplifier.

## Patentansprüche

1. Integrierte Halbleiterschaltungsanordnung, umfassend:
eine interne Energieversorgung, die dazu betriebsfähig ist, eine externe Versorgungsspannung (EVCC) zu empfangen und eine davon abhängige niedrige interne Versorgungsspannung (IVCC) bereitzustellen,
einen ersten Verstärker (2), um ein Signal (n1) von internen Schaltkreisen des Gerätes zu verstärken und eine dazu entsprechende erste Verstärkerausgabe (n2) zu liefern;
einen zweiten Verstärker (3), um die erste Verstärkerausgabe (n2) zu verstärken und eine dazu entsprechende zweite Verstärkerausgabe (n4) zu liefern; und
einen Ausgabetreiber (5), um eine der zweiten Verstärkerausgabe (n4) entsprechenden Treiberausgabe (OUT) zu liefern;
**dadurch gekennzeichnet, dass**
der erste Verstärker (2) dazu eingerichtet ist, durch die interne Versorgungsspannung (IVCC) getrieben zu werden, und der zweite Verstärker (3) und der Ausgabetreiber (5) dazu eingerichtet sind, durch die externe Versorgungsspannung (EVCC) getrieben zu werden.

2. Integrierte Halbleiterschaltungsanordnung nach Anspruch 1, wobei der erste Verstärker (2) zwischen der internen Energieversorgungsspannung (IVCC) und einer dritten Energieversorgungsspannung (VSS) angeschlossen und dazu eingerichtet ist, aus einer Speicherzelle ausgelesene Daten zu empfangen und zu verstärken; und
der zweite Verstärker (3) zwischen der externen Energieversorgungsspannung und der dritten Energieversorgungsspannung (VSS) angeschlossen und dazu eingerichtet ist, Daten von der Pegelausgabe der internen Energieversorgungsspannung des ersten Verstärkers (2) zu empfangen und zu verstärken und den Pegel der Daten in den Pegel der externen Energieversorgungsspannung umzuwandeln.

3. Integrierte Halbleiterschaltungsanordnung nach Anspruch 1, wobei die interne Energieversorgung dazu eingerichtet ist, die interne Energieversorgungsspannung (IVCC) durch Erzeugung einer vorbestimmten Spannung in einem ersten Bereich und durch Erhöhung der erzeugten Spannung mit einer vorbestimmten Rate in einem zweiten Bereich in Übereinstimmung mit einem Anstieg der externen Energieversorgungsspannung (EVCC) zu liefern;
die internen Schaltkreise von der im ersten Bereich erzeugten Spannung getrieben werden;
das durch den ersten Verstärker (2) verstärkte Signal aus einer Speicherzelle ausgelesene Daten sind; und
der zweite Verstärker (3) dazu eingerichtet ist, die erste Verstärkerausgabe in Daten des Pegels der externen Energieversorgungsspannung umzuwandeln.

4. Integrierte Halbleiterschaltungsanordnung nach Anspruch 3, wobei der zweite Verstärker (13) zwischen der externen Energieversorgung und einem Masseanschluss angeschlossen ist, umfassend:
eine Steuerschaltung (16), die dazu eingerichtet ist, zwischen Leitung und Nichtleitung eines MOS-Transistors (N4, N5) auf der Masseanschlussseite des zweiten Verstärkers (13) in Übereinstimmung mit einem Aktivierungssignal (RAC) und einer Ausgabe des zweiten Verstärkers (13) zu schalten.

5. Integrierte Halbleiterschaltungsanordnung nach Anspruch 3, wobei der zweite Verstärker (23) zwischen der externen Energieversorgung und einem Masseanschluss angeschlossen ist, umfassend:
eine Steuerschaltung (26), die dazu eingerichtet ist, zwischen Leitung und Nichtleitung eines MOS-Transistors (N6) auf der Masseanschlussseite des zweiten Verstärkers (23) in Übereinstimmung mit einem Einbrenn-Freigabesignal (BI) und einem Aktivierungssignal (RAC) zu schalten.

6. Integrierte Halbleiterschaltungsanordnung nach einem der Ansprüche 2 bis 5, wobei der erste Verstärker (2) dazu eingerichtet ist, Daten in Übereinstimmung mit dem gelesenen Verstärkeraktivierungssignal (RAC) zu verstärken.

7. Integrierte Halbleiterschaltungsanordnung nach einem der Ansprüche 2 bis 6, wobei der zweite Verstärker (3) dazu eingerichtet ist, Daten in Übereinstimmung mit einem Adresszeilen-Freigabesignal (RAE) zu verstärken.

8. Integrierte Halbleiterschaltungsanordnung nach einem der Ansprüche 2 bis 7, wobei der erste und der zweite Verstärker (2, 3) unter Verwendung eines Strom-Spiegelverstärkers bzw. eines differentiellen Verstärkers eingerichtet sind.

## Revendications

1. Dispositif de circuit intégré à semi-conducteurs comprenant :
• un bloc d'alimentation interne ayant pour fonction de recevoir une tension d'alimentation externe (EVCC) et de fournir une tension inférieure d'alimentation interne (IVCC) dépendant de celle - ci ;
• un premier amplificateur (2) pour amplifier un signal (n1) provenant des circuits internes du dispositif et pour fournir une première sortie d'amplificateur (n2) y correspondant ;
• un second amplificateur (3) pour amplifier la première sortie d'amplificateur (n2) et pour fournir une seconde sortie d'amplificateur (n4) y correspondant ; et
• un gestionnaire de sortie (5) pour fournir une sortie de gestionnaire (OUT) correspondant à la seconde sortie d'amplificateur (n4) ;
**caractérisé en ce que :**
le premier amplificateur (2) est conformé pour être commandé par la tension d'alimentation interne (IVCC), et le second amplificateur (3) et le gestionnaire de sortie (5) sont conformés de façon à être commandés par la tension d'alimentation externe (EVCC).

2. Dispositif de circuit intégré à semi-conducteurs selon la revendication 1, dans lequel :
le premier amplificateur (2) est connecté entre ladite tension de bloc d'alimentation interne (IVCC) et une troisième tension de bloc d'alimentation (VSS) et conformé pour recevoir et amplifier les données lues depuis une cellule de mémoire ; et
le second amplificateur (3) est connecté entre ladite tension de bloc d'alimentation externe et ladite troisième tension de bloc d'alimentation (VSS) et conformé pour recevoir et amplifier des données dudit niveau de tension du bloc d'alimentation interne émises par ledit premier amplificateur (2) et pour convertir le niveau des données en ledit niveau de tension du bloc d'alimentation externe.

3. Dispositif de circuit intégré à semi-conducteurs selon la revendication 1, dans lequel :
le bloc d'alimentation interne est conformé pour fournir la tension du bloc d'alimentation interne (IVCC) en générant, dans une première zone, une tension prédéterminée et, dans une seconde zone, en augmentant ladite tension générée à un débit prédéterminé selon une augmentation de la tension du bloc d'alimentation externe (EVCC) ;
les circuits internes sont actionnés à partir de la tension générée dans ladite première zone ;
le signal amplifié par le premier amplificateur (2) consiste en des données lues à partir d'une cellule de mémoire ; et
le second amplificateur (3) est conformé pour convertir la sortie du premier amplificateur en des données du niveau de tension du bloc d'alimentation externe.

4. Dispositif de circuit intégré à semi-conducteurs selon la revendication 3, dans lequel le second amplificateur (13) est connecté entre ledit bloc d'alimentation externe et la masse, comprenant :
un circuit de contrôle (16) conformé pour commuter entre la conduction et la non conduction d'un transistor MOS (N4, N5) au niveau de la masse dudit second amplificateur (13) selon un signal d'activation (RAC) et à une sortie depuis ledit second amplificateur (13).

5. Dispositif de circuit intégré à semi-conducteurs selon la revendication 3, dans lequel le second amplificateur (23) est connecté entre ledit bloc d'alimentation externe et la masse, comprenant :
un circuit de contrôle (26) conformé pour commuter entre la conduction et la non conduction d'un transistor MOS (N6) au niveau de la masse dudit second amplificateur (23) selon un signal de validation de déverminage (BI) et un signal d'activation (RAC).

6. Dispositif de circuit intégré à semi-conducteurs selon l'une des revendications 2 à 5,
dans lequel ledit premier amplificateur (2) est conformé pour amplifier des données conformément à un signal actif d'amplificateur lu (RAC).

7. Dispositif de circuit intégré à semi-conducteurs selon l'une des revendications 2 à 6,
dans lequel ledit second amplificateur (3) est conformé pour amplifier des données conformément à un signal de validation d'adresse ligne (RAE).

8. Dispositif de circuit intégré à semi-conducteurs selon l'une des revendications 2 à 7,
dans lequel lesdits premiers et second amplificateurs (2, 3) sont configurés respectivement en utilisant un amplificateur de type miroir de courant et un amplificateur différentiel.
